# EUROPEAN PATENT APPLICATION

(11) **EP 4 672 323 A1**
(43) Date of publication of application: **31.12.2025**
(21) Application number: 25169737.1
(22) Date of filing: 10.04.2025
(51) Int. Cl.: H01L 23/367, H01L 23/373, H01L 23/40

(54) **ELECTRONIC CONTROL UNIT**

(30) Priority: 25.06.2024 WO PCT/CN2024/101142; 27.12.2024 US 202419002797
(71) Applicant: Intel Corporation, Santa Clara, CA 95054 (US)
(72) Inventor: NAAS, Nico, 76139 Karlsruhe (DE); SUBRAHMANYAM, Prabhakar, San Jose (US)
(74) Representative: Viering, Jentschura & Partner mbB Patent- und Rechtsanwälte

(57) **Abstract**

An electronic control unit may include a carrier; a system-on-chip structure disposed over the carrier, the system-on-chip structure comprising one or more bare dies; a heat spreader thermally coupled to the one or more bare dies; a gap filler material thermally coupled to the heat spreader; and a heat sink structure thermally coupled to the gap filler material. The gap filler material is a thermal interface material. The heat spreader and the carrier are biased relative to each other in an elastic manner.

## Description

### Cross-Reference to Related Applications

This application claims priority to PCT Application PCT/CN2024/101142, which was filed on June 25, 2024, the entire contents of which are incorporated herein by reference.

### Background

An electronic control unit (ECU) is an embedded system in automotive electronics that controls one or more of the electrical systems or subsystems in a car or other vehicle, e.g. motor vehicle. Because the number of ECUs in modern vehicles has greatly increased, the trend is toward more powerful centralized ECUs, in which simple controllers are replaced by powerful CPUs that can perform the tasks of multiple simple controllers.

### Brief Description of the Drawings

In the drawings, like reference characters generally refer to the same parts throughout the different views. The drawings are not necessarily to scale, emphasis instead generally being placed upon illustrating the principles of the disclosed subject matter. In the following description, various embodiments of the disclosed subject matter are described with reference to the following drawings, in which:
FIG. 1 shows a vehicle including a plurality of sensors;
FIG. 2 shows various electronic components of an electronic system of the vehicle;
FIG. 3 shows a cross sectional view of a conventional electronic control unit;
FIG. 4 shows a cross sectional view of an electronic control unit in accordance with various aspects of this disclosure;
FIG. 5 shows a cross sectional view of an electronic control unit in accordance with various aspects of this disclosure;
FIG. 6 shows a cross sectional view of an electronic control unit in accordance with various aspects of this disclosure;
FIG. 7 shows a cross sectional view of an electronic control unit in accordance with various aspects of this disclosure; and
FIG. 8 shows a flow diagram illustrating a method of manufacturing an electronic control unit in accordance with various aspects of this disclosure.

### Description

The following detailed description refers to the accompanying drawings that show, by way of illustration, specific details and embodiments in which the underlying principles may be practiced.

Various aspects of this disclosure provide an appliance to enable a high performance and robust cooling solution for bare-die SOCs in vehicle and other harsh environments.

An electronic control unit (ECU) is an embedded system in automotive electronics that controls one or more of the electrical systems or subsystems in a car or other vehicle, e.g. motor vehicle. Various examples of a motor vehicle may include a motor train, a motor truck, a motor boat, a plane, all being equipped e.g. with a conventional combustion engine and/or electric drive(s).

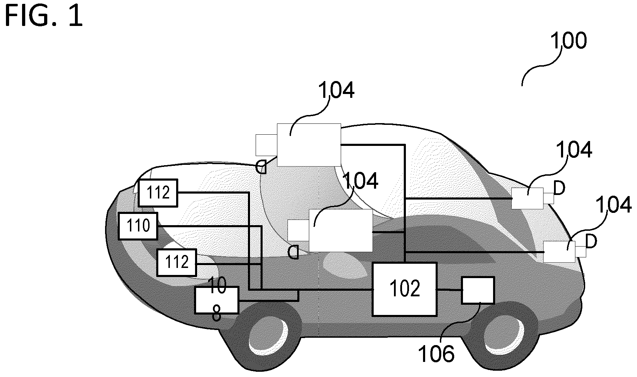

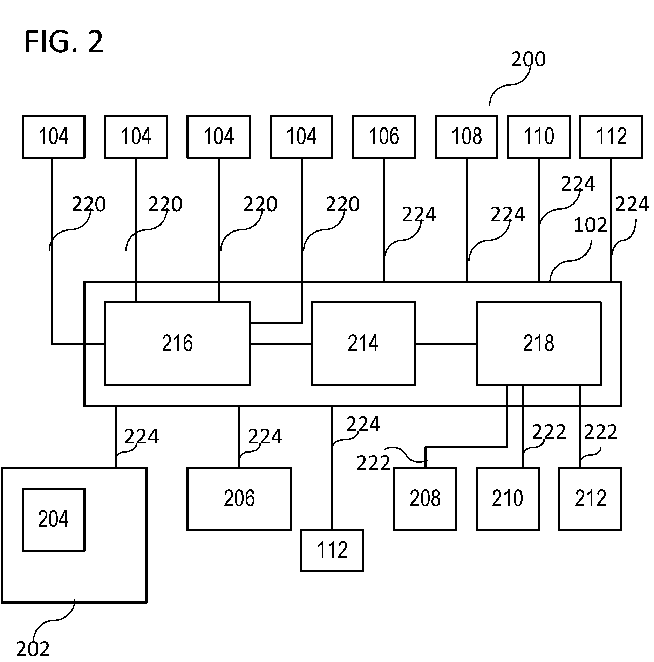

FIG. 1 shows a vehicle 100 including an electronic system 200 (see also FIG. 2) in accordance with various aspects of this disclosure. The electronic system 200 may include various electronic components depending on the requirements of a particular implementation. As shown in FIG. 1 and FIG. 2, the electronic system 200 may include one or more processors 102 (which may also be referred to as one or more electronic control units), one or more image acquisition devices 104 such as e.g. one or more cameras, a position sensor 106 such as a Global Navigation Satellite System (GNSS), e.g. a Global Positioning System (GPS), one or more memories 202, a map database 204, one or more user interfaces 206 (such as e.g. a display, a touch screen, a microphone, a loudspeaker, one or more buttons and/or switches, and the like), and one or more wireless transceivers 208, 210, 212. The wireless transceivers 208, 210, 212 may be configured to different desired radio communication protocols or standards. By way of example, a first wireless transceiver (e.g., of the wireless transceivers 208) may be configured in accordance with a Short Range mobile radio communication standard such as e.g. Bluetooth, Zigbee, and the like. Furthermore, a second wireless transceiver 210 may be configured in accordance with a Medium or Wide Range mobile radio communication standard such as e.g. a 3G (e.g. Universal Mobile Telecommunications System - UMTS), a 4G (e.g. Long Term Evolution - LTE), or a 5G mobile radio communication standard in accordance with corresponding 3GPP (3^{rd} Generation Partnership Project) standards. A third wireless transceiver 212 may be configured in accordance with a Wireless Local Area Network communication protocol or standard such as e.g. in accordance with IEEE 802.11 (e.g. 802.11, 802.11a, 802.11b, 802.11g, 802.11n, 802.11p, 802.11-12, 802.11ac, 802.11ad, 802.11ah, and the like). The one or more wireless transceivers 208, 210, 212 may be configured to transmit signals via an air interface. The image acquisition devices 104 may each include any type of device suitable for capturing at least one image from an environment of the vehicle 100. Moreover, any number of image acquisition devices 104 may be used to acquire images to input to a processor such as an image processor.

The one or more processors 102 may include a processor 214 (e.g., an application processor), an image processor 216, a communication processor 218, or any other suitable processing device such as one or more electronic control units (ECUs), which may be configured to control one or more electronic components, such as those mentioned above or one or more optical sensors such as LIDAR sensors, one or more RADAR sensors, one or more acoustic sensors, and the like. Similarly, image acquisition devices 104 may include any number of image acquisition devices and components depending on the requirements of a particular application. Image acquisition devices 104 may include one or more image capture devices (e.g., cameras, CCDs (charge coupling devices), or any other type of image sensor). The electronic system 200 may also include a data interface communicatively connecting the one or more processors 102 to the image acquisition devices 104. For example, a first data interface may include any wired and/or wireless first link 220 (or first links) for transmitting image data acquired by image acquisition devices 104 to the one or more processors 102, e.g. to the image processor 216.

Each ECU of the one or more ECUs may include one or more system-on-chip (SoC) structures. Each SoC structure may include one or more bare dies.

The wireless transceivers 208, 210, 212 may be coupled to the one or more processors 102, e.g. to the communication processor 218, e.g. via a second data interface which may include any wired and/or wireless link of the second links 222 or second links 222 for transmitting radio transmitted data acquired by wireless transceivers 208, 210, 212 to the one or more processors 102, e.g. to the communication processor 218.

The memories 202 as well as the one or more user interfaces 206 may be coupled to each of the one or more processors 102, e.g. via a third data interface which may include any wired and/or wireless link of the third links. Furthermore, the position sensor 106 may may be coupled to each of the one or more processors 102, e.g. via the third data interface.

Such transmissions may also include communications (one-way or two-way) between the vehicle 100 and one or more other (target) vehicles in an environment of the vehicle 100 (e.g., to facilitate coordination of navigation of the vehicle 100 in view of or together with other (target) vehicles in the environment of the vehicle 100), or even a broadcast transmission to unspecified recipients in a vicinity of the vehicle 100 (e.g. the transmitting vehicle).

One or more of the one or more wireless transceivers 208, 210, 212 may be configured to implement one or more vehicle to everything (V2X) communication protocols.

Each processor 214, 216, 218 of the one or more processors 102, and thus also each ECU may include various types of hardware-based processing devices. By way of example, each processor 214, 216, 218 may include a microprocessor, pre-processors (such as an image preprocessor), graphics processors, a central processing unit (CPU), support circuits, digital signal processors, integrated circuits, memory, or any other types of devices suitable for running applications and for image processing and analysis. In some embodiments, each processor 214, 216, 218 may include any type of single or multi-core processor, mobile device microcontroller, central processing unit, etc. These processor designs may each include multiple processing units with local memory and instruction sets. Such processors may include video inputs for receiving image data from multiple image sensors and may also include video output capabilities.

Any of the processors 214, 216, 218 disclosed herein may be configured to perform certain functions in accordance with program instructions which may be stored in a memory of the one or more memories 202. In other words, a memory of the one or more memories 202 may store software that, when executed by a processor (e.g. by the one or more processors 102), controls the operation of the system, e.g. the system. A memory of the one or more memories 202 may store one or more databases and image processing software, as well as a trained system, such as a neural network, or a deep neural network, for example. The one or more memories 202 may include any number of random access memories, read only memories, flash memories, disk drives, optical storage, tape storage, removable storage and other types of storage.

The electronic system 200 may further include further electronic components such as a speed sensor 108 (e.g., a speedometer) for measuring a speed of the vehicle 100. The electronic system 200 may also include one or more accelerometers (either single axis or multiaxis) (not shown) for measuring accelerations of the vehicle 100 along one or more axes. The electronic system 200 may further include additional sensors or different sensor types such as an ultrasonic sensor, a thermal sensor, one or more radar sensors 110, one or more LIDAR sensors 112 (which may be integrated in the head lamps of the vehicle 100), and the like. The radar sensors 110 and/or the LIDAR sensors may be configured to provide pre-processed sensor data, such as radar target lists or LIDAR target lists. The third data interface may couple the speed sensor 108, the one or more radar sensors 110 and the one or more LIDAR sensors 112 to each of the one or more processors 102.

Each ECU may be associated with one or more of the electronic components or further electronic components as outlined above and may be configured to receive and process data from the associated one or more of the electronic components or further electronic components, to transmit control signals to associated one or more of the electronic components or further electronic components, thereby controlling the same.

The one or more memories 202 may store data, e.g. in a database or in any different format, that e.g. indicate a location of known landmarks. The one or more processors 102 may process sensory information (such as images, radar signals, depth information from LIDAR or stereo processing of two or more images) of the environment of the vehicle 100 together with position information, such as a GPS coordinate, vehicle's ego motion, etc. to determine a current location of the vehicle 100 relative to the known landmarks, and refine the vehicle location. Certain aspects of this technology are included in a localization technology such as a mapping and routing model.

The map database 204 may include any type of database storing (digital) map data for the vehicle 100, e.g. for the electronic system 200. The map database 204 may include data relating to the position, in a reference coordinate system, of various items, including roads, water features, geographic features, businesses, points of interest, restaurants, gas stations, etc.

As described above, the vehicle 100 may include the electronic system 200 (e.g., a safety system) as also described with reference to FIG. 2.

The vehicle 100 may include the one or more processors 102 e.g. integrated with or separate from an engine control unit of the vehicle 100.

The one or more processors 102 of the vehicle 100 may implement the following aspects and methods.

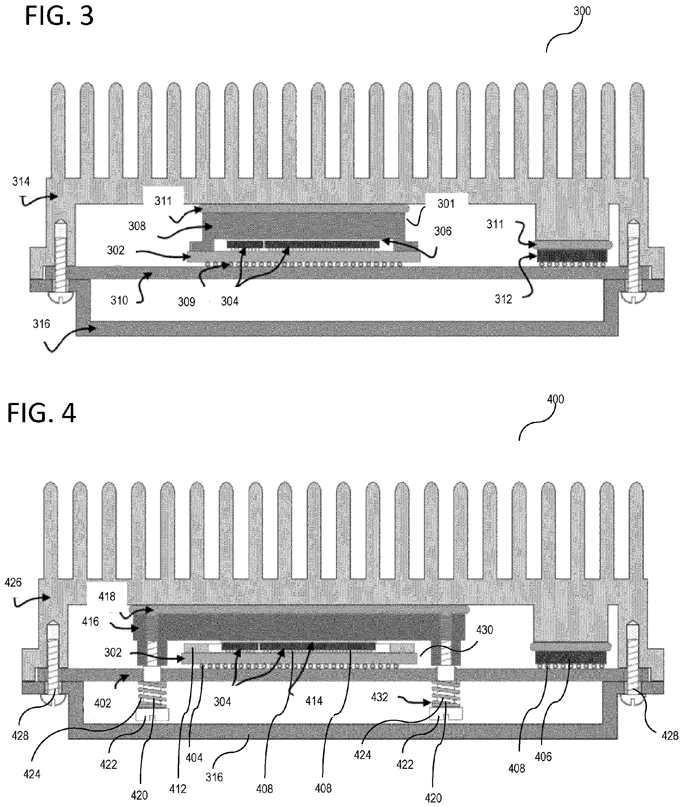

The cross section through a stack-up of an ECU 300 is shown in FIG. 3. The conventional system-on-chip (SoC) 301 includes a substrate 302. One or more packaged silicon dies 304 are mounted on the substrate 302. A thin first thermal interface material TIM1 306 (Thermal Interface Material - level 1) is disposed on the upper surface of the packaged silicon dies 304 and is configured to transfer the heat into an integrated heat spreader 308 (IHS). This conventional SoC is soldered down with a ball grid array (BGA) 309 onto a printed circuit board (PCB) 310. The IHS 308 increases the small surface of the packaged silicon dies 304 to a wider area for heat transfer into a second thermal interface material TIM2 311 (Thermal Interface Material - level 2). The second thermal interface material TIM2 (usually a 2K-Gap Filler) transfers the heat out of the heat spreader, i.e. the integrated heat spreader 308 or other hot spots 312 into the heat sink 314 (Air or Liquid) where it is removed from the system, in other words from the ECU 300.

It is to be noted that the conventional ECU only provides a system for an SoC with dies covered/lidded by an integrated heat spreader (IHS).

Various aspects of this disclosure, however, achieve a stable ECU stack system including one or more system-on-chip (SoC) structures, each SoC including one or more non-lidded or exposed dies (e.g. one or more silicon bare dies) instead of the conventional silicon SoC with dies covered/lidded by an IHS being robust even with a lot of vibrations which may occur in a driving vehicle. This is illustratively achieved by using a gap filler material as the thermal interface material-level 2, which has the characteristic that it is in liquid form when applied on a heat spreader and hardened after the application onto the heat spreader.

It is to be noted that unlike a conventional SoC with an IHS, a bare-die SoC (being free from an IHS) may have a metal stiffener plate around the bare-die.

In the conventional ECU's in a vehicle using an SoC with dies covered/lidded by an IHS, the second thermal interface material TIM2 usually covers stack tolerances in the Z-direction, resulting in a necessary so called Bond Line Thickness (BLT) of about 0.4 mm to about 0.8 mm.

However, if this typical range of BLT of the TIM2 is used as a TIM1 on a bare-die SoC with its small heat-generating surface, it would result in a higher thermal resistance and thus a high temperature in the heat-generating bare die, even with best performance cooling in the heat sink. This issue is addressed in laptops by employing a first thermal interface material TIM1, which is compressed into a thin BLT (0.02-0. 1mm) by a force generated by a spring. This approach has not yet been implemented in the automotive industry due to concerns about the compatibility of vehicle vibrations with a spring/mass system in an ECU. Consequently, the potential for damaging the bare chip and pumping out the thermal interface materials TIM has led to the avoidance of a high-performance spring load system for cooling in an ECU for a vehicle.

FIG. 4 shows a cross sectional view of an electronic control unit 400 in accordance with various aspects of this disclosure.

The electronic control unit 400 may include a carrier 402, e.g. a printed circuit board (PCB). A system-on-chip (SoC) structure (s) (e.g. a system-on-chip (SoC) package (s) or simply a system-on-chip (SoC), also referred to as bare die system-on-chip (SoC)), e.g. a silicon SoC structure, may be disposed, e.g. mounted, on a main surface of the carrier 402. By way of example, the SoC structure may be soldered to the main surface of the carrier 402. The SoC structure may include a substrate 302, a grid array 404, e.g. a ball grid array 404 formed on the lower side of the substrate 302, soldered to the carrier 402, thereby fixing, e.g. soldering, the SoC package (s) to the carrier 402. The SoC package (s) may include one or more silicon dies 304 (and optionally in addition e.g. one or more memories, one or more memory interfaces, one or more input/output (I/O) devices and interfaces. One or more further active components 406 (non bare die packages) in need of cooling may be disposed on the carrier 402 that can be cooled by the same heat sink 314 that is in contact with TIM2 311. These one or more active components 406 could be one or any combination compromised of a voltage regulator, a memory, one or more inductors, one or more FPGAs (Field Programmable Gate Arrays), one or more switches, or any other heat emitting soldered down part and the like. In summary, the SoC package (s) may include the substrate 302, the grid array 404, the one or more silicon dies 304, an optional stiffener plate 412 (which will be described further below), and a further grid array 408 (which will also be described further below).

The SoC package (s) including the one or more bare silicon dies 304 may be disposed, e.g. mounted, on a main surface of the carrier 402. By way of example, the SoC package (s) including the one or more bare silicon dies 304 may be soldered to the main surface of the carrier 402. The SoC package (s) including the one or more silicon dies 304 may include a further grid array 408, e.g. a further ball grid array 410, soldered to the substrate 302, thereby fixing, e.g. soldering, the SoC package (s) including the one or more silicon dies 304 to the carrier 402. The one or more bare silicon dies 304 may e.g. include a processing silicon die (e.g. an application processing silicon die) and/or a communication processing die, e.g. a Platform Controler Hub (PCH) silicon die configured to provide the PCH communication.

As briefly described above, the ECU 400 with the SoC package (s) including the one or more silicon dies 304 may include an optional (e.g. metal) stiffener plate 412 laterally surrounding the one or more bare silicon dies 304.

The one or more silicon dies 304 may include any type of die, e.g. a logic die, e.g. including one or more processors, in general any type of processor implementing logic. Alternatively or in addition, the one or more silicon dies 304 may include one or more power semiconductor dies. By way of example, the one or more silicon dies 304 may include one or more of the following types of dies: one or more PCH silicon dies, one or more Graphics Processing Unit silicon dies (GPU silicon dies), one or more memory silicon dies, one or more I/O silicon dies, one or more Neuromorphic Processor Unit silicon dies (NPU silicon dies), one or more Intelligence Processing Unit silicon dies (IPU silicon dies), and the like.

The electronic control unit 400 may further include a heat spreader 416 thermally coupled to the one or more bare silicon dies 304. A first thermal interface material (TIM1) 414 may be provided between the upper surface of the one or more bare silicon dies 304 and the heat spreader 416. The heat spreader 416 may be configured to increase the small upper surface of the one or more bare silicon dies 304 to a wider area (provided by the heat spreader 416) for a heat transfer into a second thermal interface material TIM2 418, in the following also referred to as a gap filler material 418, which is thermally coupled to the heat spreader 416. The heat spreader 416 may include or be made of one or more metals, e.g. copper (Cu), silver (Ag), aluminum (Al), or any alloy of these metals. By way of example, the heat spreader 416 may include or be made of a vapor chamber or a heat pipe or a heat spreader with embedded or integrated phase change device as a heat pipe or a vapor chamber.

The gap filler material 418 may include two components (i.e. the gap filler material 418 may be a two component material that react with each other by mixing). The gap filler material 418 may be in liquid form when applied on the heat spreader 416 and hardened after the mixing and application on the heat spreader 416. A first component of the gap filler material 418 may be a matrix material such as (elastic) silicon or any other suitable elastic material. For instance, silicone rubber can be enhanced by introducing silicon carbide (SiC) fillers, improving its electrical, thermal, and mechanical properties. The second component of the gap filler material 418 may be a filler material (also referred to as filler). The filler material may e.g. be a metal-based filler material. The metal-based filler material may include one or more materials selected from a group of materials consisting of aluminum oxide (Al₂O₃); zinc oxide (ZnO); silver (Ag); and/or copper (Cu); and the like. As an alternative or in addition, the filler material may e.g. be a carbon-based filler material. The carbon-based filler material may include one or more materials from a group of materials consisting of carbon nanotubes (CNTs); graphene; and/or diamond particles; and the like. As another alternative or in addition, the filler material may e.g. be a ceramic-based filler material. The ceramic-based filler material may include one or more materials from a group of materials consisting of boron nitride (BN); aluminum nitride (AlN); and/or silicon carbide (SiC); and the like.

The choice of the filler material depends on factors such as thermal conductivity, electrical insulation properties, cost, and compatibility with other components used in the ECU 400. Metallic fillers like silver and copper offer high thermal conductivity but can be rather expensive and could be electrically conductive. The metal oxide fillers such as aluminum oxide (Al₂O₃); zinc oxide (ZnO) and the like are normally electrically insulating. Carbon-based fillers like CNTs and graphene have excellent thermal properties while being lightweight. Ceramic fillers like BN and AlN provide good thermal conductivity and electrical insulation.

The filler materials are typically dispersed in a base matrix or carrier, which can be a silicone, epoxy, or other polymer-based material. The combination of filler and matrix creates a thermally conductive paste, pad, or phase-change material that can effectively transfer heat away from the heat source.

It is to be noted that any suitable curing liquid TIM2 may be provided. The curing liquid material TIM2 cures/hardens to a solid state after its application and by this fixes the position of the spring load heat spreader while covering the tolerances induced by the parts and the assembly process in stack orientation.

The electronic control unit 400 may further include a heat sink structure 426 thermally coupled to the gap filler material 418. The gap filler material 418 is a thermal interface material, e.g. a thermal interface material level 2. The heat spreader 416 and the carrier 402 are biased relative to each other in an elastic manner. By way of example, the heat spreader 416 and the carrier 402 are biased relative to each other via one or more springs. By way of example, the electronic control unit 400 may include a biasing structure configured to bias the heat spreader 416 and the carrier 402 relative to each other in an elastic manner. The biasing structure 420 may include one or more screws 422 (and optionally one or more associated screw nuts) to fasten the heat spreader 416 to the carrier 402 and a spring 424 positioned between e.g. a respective screw head of a respective screw 422 and the carrier 402.

The one or more screws 422 may include self-tapping screws, screws with screw locks, form fit screws that prevent the screws to get loose, and the like.

In various aspects of this disclosure, the heat sink structure 426 is fixed to the carrier 402 in a releasable manner, e.g. by one or more screws 428. By way of example, the one or more screws may fix the heat sink structure 426 to the carrier 402 by screwing a lower housing portion 430 to the heat sink structure 426, thereby clamping the three components together, namely the heat sink structure 426, the lower housing portion 430 and the carrier 402 sandwiched between the heat sink structure 426 and the lower housing portion 316.

In various aspects of this disclosure, a novel stack-up of an ECU is provided that enables the use of a bare-die SoC in a vehicle, e.g. a car.

The ECU 400 may include:
- an external spring-load 432 heat spreader 416 with a (e.g. best-in-class phase change) first thermal interface material TIM1 306 to get the BLT to the minimum of 0.02-0.03mm. With this very thin bond line thickness (BLT), the heat flows easily through the first thermal interface material TIM1 306 and into the heat spreader 416 against a very low thermal impedance; but it can't cover with this thin bond line the tolerances in Z-direction.
- the prevention of damage caused by vibration is another aspect in the vehicle industry, and as such, the use of a spring load mass is not yet implemented;
- to overcome this problem, e.g. a two-part curing second thermal interface material TIM2 311 is used to cover the necessary tolerances in the Z-direction. The second thermal interface material TIM2 311 is mixed and applied in a liquid state over the larger surface area between the spring-loaded heat spreader 416 and the heat sink structure 426, e.g. a heat sink 314. The second thermal interface material TIM2 311 cures after the assembly to a semi-solid rubber-like state that dampens and counteracts the free movement of the heat spreader 416 to prevent damage to the bare-die SoC by restricting possible movement of the heatspreader induced by vibration.

The heat sink structure 426 may include a plurality of ribs extending from a heat sink base. As an alternative or in addition, a fined heat sink structure that works with air may be provided. As an alternative or in addition, the heat sink structure may include or be a liquid cooling device, or a heat pipe that transfers the heat away from the ECU 400, e.g. away from the (active) one or more bare dies 304. The heat sink structure 426 may include cooling structures using e.g. closed loop liquid cooling, active liquid cooling, thermo electric cooling, phase change cooling like a thermo syphon or heat removal via high K plates, or vapor chamber, and the like.

The effects of various aspects of this disclosure are manifold:
- First, it allows to implement ECUs with bare dies in the automotive inductry to enable such SoCs for the usage in the automotive industry.
- Second, it enables the designer of an ECU to scale the heat spreader in size and thickness according to the thermal boundary conditions. This gives more flexibility even compared to a SoC with an IHS.

The thermal problem can be greatly improved with the approach described above. Furthermore, the eleastic biasing of the heat spreader and the carrier relative to each other overcome the problem of potential damage to the (e.g. Si) bare dies by the heat spreader.

The spring force defines a precise pressure to guarantee the very thin first thermal interface material TIM1 e.g. phase change TIM or the like. However, this force may be too small to prevent the heat spreader from separating during vibration. A gap filler material is provided which can be mixed and applied in a liquid state to the upper main surface of the heat spreader (i.e. between the heat spreader and the heat sink structure), conforms to its final shape and BLT, and then cures in place to a rubber-like consistency. It may bond the heat spreader to the heat sink structure over an order of magnitude (e.g. 10 times to 40 times) larger area than the first thermal interface material TIM1contact patch. The hardness of the second thermal interface material TIM2 after curing (in other words after hardening) in Shore00 may be in the range from about 60 to about 100, e.g. in the range from about 65 to about 100, e.g. in the range from about 75 to about 90, e.g. approximately or exactly 75, which illustratively is a hardness between a rubber band and a rubber eraser. This may provide a very strong dampening without any possibility of free travel for the heat spreader. This may prevent hard mechanical impacts of the heat spreader on the bare die. In general, the higher the Shore00 value, the harder the second thermal interface material TIM2 becomes and the more the spring constant of the second thermal interface material TIM2 increases and thus, the more the second thermal interface material TIM2 prevents movement by vibration.

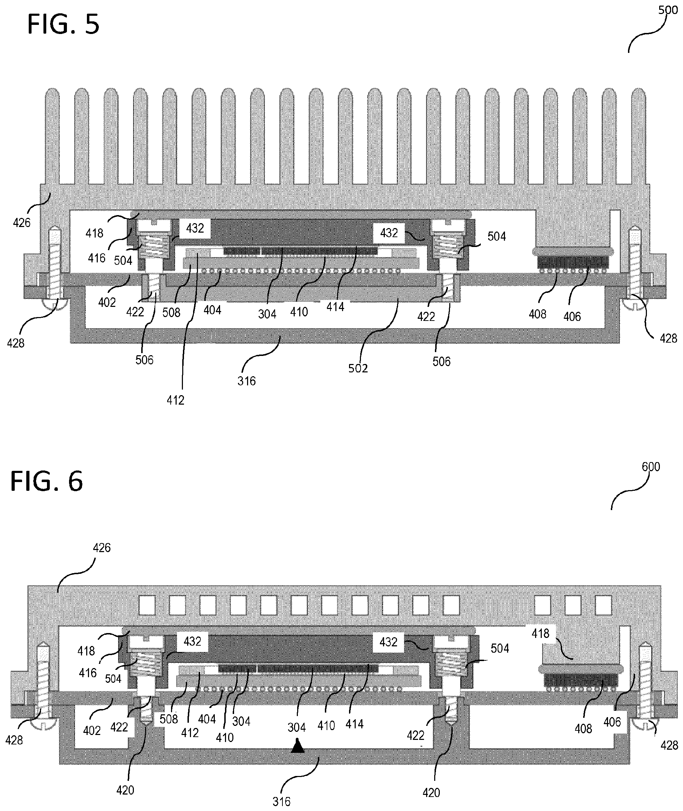

FIG. 5 shows a cross sectional view of an electronic control unit in accordance with various aspects of this disclosure.

FIG. 5 shows a cross sectional view of an electronic control unit 500 in accordance with various aspects of this disclosure. The ECU 500 of FIG. 5 is similar to the ECU 400 of FIG. 4, the one or more springs 504 may be located on the top side of the carrier 402 (e.g. the PCB) instead of the bottom side of the carrier 402 (e.g. the PCB). The effect is the same but additionally has a backplate 502, e.g. a metal backplate 502, mounted to the carrier 402 and the heat spreader 416 using the one or more screws 506. The backplate 502 may be in physical contact with the lower surface of the carrier 402 opposite the SoC structure 508.

As shown in the ECU 600 of FIG. 6 is similar to the ECU 500 of FIG. 5 but the screws are screwed to standoffs in the bottom cover that are in contact with the lower surface of the carrier 402. Furthermore, it is possible to screw into a back plate (as shown in FIG. 5) with threaded holes instead of a nut or it may be provided to screw into the heat spreader 416 when it has a threaded hole (as shown in the exemplary ECU 400 of FIG. 4).

Illustratively, the screws 422 and springs 504 of the ECU 600 of FIG. 6 are provided as inverted spring/screw orientation. This structure secures the screw hole standoffs to the chassis of the ECU 600, thereby preventing any relative movement in the X-Y direction. In this example, the heat sink structure 426 is implemented as a liquid cold plate chassis instead of an air cooled heat sink structure in the ECU 400 of FIG. 4. In this example, a closed loop heat exchanger (radiator) connected to the cold plate may be provided, as the coolant is re-circulated from the cold plate to be cooled.

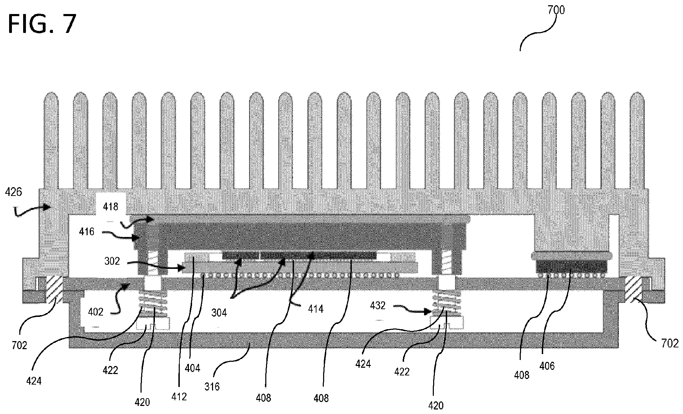

As an alternative, as shown in FIG. 7, in the ECU 700, the heat sink structure 426 may be fixed to the carrier 402 in a non-releasable manner. By way of examples, the heat sink structure 426 may be soldered to the carrier 402. As shown in FIG. 7, the lower housing portion 316 and the carrier 402 may be fixed to the heat sink structure 426 by solder 702 in a non-releasable manner.

Such a fixing may prevent a second thermal interface material TIM2 311 shearing, particularly prevalent in automotive applications where shock and vibration may gradually unscrew and cause the heat sink structure 426 to vibrate, possibly resulting in the shearing of the second thermal interface material TIM2 311.

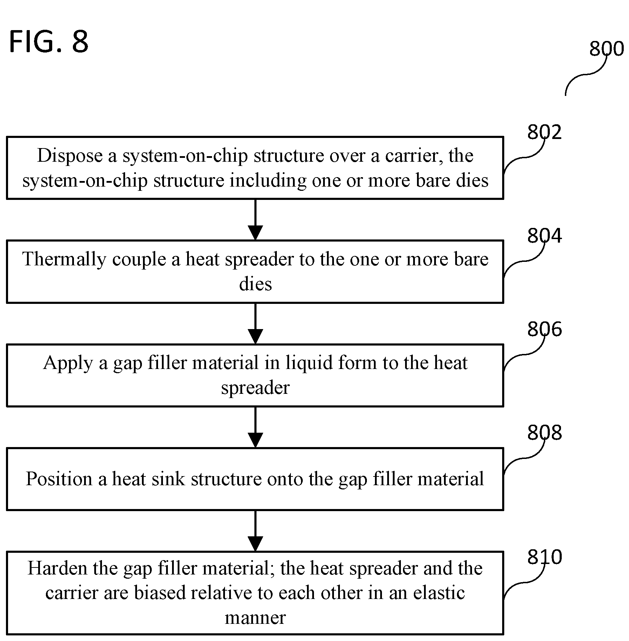

FIG. 8 shows a flow diagram 800 illustrating a method of manufacturing an electronic control unit 400, 500, 600, 700 in accordance with various aspects of this disclosure.

The method includes, in 802, disposing a system-on-chip package (s) on a carrier 402, the system-on-chip structure including one or more bare silicon dies 304, and, in 804, thermally coupling a heat spreader 416 to the one or more bare silicon dies 304. The method further includes, in 806, applying a gap filler material 418 in liquid form to the heat spreader 416, and, in 808, positioning a heat sink structure 426 onto the gap filler material 418. Optionally, the method 800 may further include conforming the gap filler material to a predefined minimum BLT that is given by the required tolerances of the assembly stack in z-direction.

The method further includes, in 810, hardening the gap filler material 418. The heat spreader 416 and the carrier 402 are biased relative to each other in an elastic, e.g. spring forced manner.

It is to be noted that the spring load heat spreader 416 is fixed by the "hardening gap filler material" to prevent potential damage caused by a vibration of the heat spreader 416, e.g. in a vehicle. When the inertia would be stronger than the clamping force of the springs 504, the heat spreader 416 would shortly disengage and fall back on the one or more bare silicon dies 304. This could cause damage. This may be prevented by the gap filler material 418.

In the following, various aspects of this disclosure will be illustrated:
Example 1 is an electronic control unit. The electronic control unit may include a carrier, a system-on-chip structure disposed over the carrier, the system-on-chip structure comprising one or more bare dies, a heat spreader thermally coupled to the one or more bare dies, a gap filler material thermally coupled to the heat spreader, and a heat sink structure thermally coupled to the gap filler material. The gap filler material is a thermal interface material. The heat spreader and the carrier are biased relative to each other in an elastic manner.

In Example 2, the subject matter of Example 1 can optionally include that the gap filler material is a silicone-based material including one or more filler materials selected from a group of filler materials consisting of one or more metal-based filler materials, one or more carbon-based filler materials, one or more ceramic-based filler materials, and/or one or more polymer-based filler materials.

In Example 3, the subject matter of any one of Examples 1 or 2 can optionally include that the carrier includes a printed circuit board.

In Example 4, the subject matter of any one of Examples 1 to 3 can optionally include that the system-on-chip structure is disposed on the carrier by a ball grid array.

In Example 5, the subject matter of any one of Examples 1 to 4 can optionally include that the one or more bare dies include one or more logic processors.

In Example 6, the subject matter of any one of Examples 1 to 5 can optionally include that the heat spreader includes or is made of one or more metals, e.g. selected from a group of metals consisting of copper (Cu), silver (Ag); aluminum (Al); or any alloy of these metals. In various examples, the heat spreader may include or be made of a vapor chamber, a heat pipe, a thermo syphon, one or more pulsating heat pipes or any other phase changing heat transfer device.

In Example 7, the subject matter of any one of Examples 1 to 6 can optionally include that the electronic control unit further includes thermal interface material configured to thermally couple the one or more bare dies to the heat spreader.

In Example 8, the subject matter of any one of Examples 1 to 7 can optionally include that the gap filler material includes two components.

In Example 9, the subject matter of any one of Examples 1 to 8 can optionally include that the gap filler material is in liquid form when applied on the heat spreader and hardened after the application.

In Example 10, the subject matter of any one of Examples 1 to 9 can optionally include that the heat sink structure includes a plurality of ribs extending from a heat sink base.

In Example 11, the subject matter of any one of Examples 2 to 10 can optionally include that the gap filler material is the silicone-based material including one or more metal-based filler materials.

In Example 12, the subject matter of Example 11 can optionally include that the one or more metal-based filler materials include material selected from a group consisting of aluminum oxide (Al₂O₃); zinc oxide (ZnO); silver (Ag); and/or copper (Cu).

In Example 13, the subject matter of any one of Examples 2 to 12 can optionally include that the gap filler material is the silicone-based material including one or more carbon-based filler materials.

In Example 14, the subject matter of Example 13 can optionally include that the one or more carbon-based filler materials include material selected from a group consisting of carbon nanotubes (CNTs); graphene; and/or diamond particles.

In Example 15, the subject matter of any one of Examples 2 to 14 can optionally include that the gap filler material is the silicone-based material including one or more ceramic-based filler materials.

In Example 16, the subject matter of Example 15 can optionally include that the one or more ceramic-based filler materials include material from a group consisting of boron nitride (BN); aluminum nitride (AlN); and/or silicon carbide (SiC).

In Example 17, the subject matter of any one of Examples 2 to 16 can optionally include that the gap filler material is the silicone-based material including one or more polymer-based filler materials.

In Example 18, the subject matter of Example 17 can optionally include that the one or more polymer-based filler materials include material from a group consisting of a silicone-based polmer; and/or an epoxy-based polymer.

In Example 19, the subject matter of any one of Examples 1 to 18 can optionally include that the heat spreader and the carrier are biased relative to each other via one or more springs.

In Example 20, the subject matter of any one of Examples 1 to 19 can optionally include that the electronic control unit further includes a biasing structure configured to bias the heat spreader and the carrier relative to each other in an elastic manner.

In Example 21, the subject matter of Example 20 can optionally include that the biasing structure includes a screw to fasten the heat spreader to the carrier and a spring positioned between a screw head of the screw and the carrier. Other mechanisms to load a spring may also be provided, such as one or more excenters, one or more levers, one or more cam shafts, and the like, so that the force can be applied in any manner.

In Example 22, the subject matter of any one of Examples 1 to 21 can optionally include that the heat sink structure is fixed to the carrier in a releasable manner.

In Example 23, the subject matter of Example 22 can optionally include that the heat sink structure is fixed to the carrier by one or more screws.

Example 24 is an electronic control unit. The electronic control unit may include a carrier; a system-on-chip structure mounted on the carrier, the system-on-chip structure comprising one or more bare dies; a heat spreader thermally coupled to the one or more bare dies; a gap filler material thermally coupled to the heat spreader; and a heat sink structure thermally coupled to the gap filler material. The gap filler material is in liquid form when applied on the heat spreader and hardened after the application. The heat spreader and the carrier are resiliently coupled to each other.

In Example 25, the subject matter of Example 24 can optionally include that the carrier includes a printed circuit board.

In Example 26, the subject matter of any one of Examples 24 or 25 can optionally include that the system-on-chip structure is mounted on the substrate by a ball grid array.

In Example 27, the subject matter of any one of Examples 24 to 26 can optionally include that the one or more bare dies include one or more logic processors.

In Example 28, the subject matter of any one of Examples 24 to 27 can optionally include that the heat spreader includes or is made of one or more metals, e.g. selected from a group of metals consisting of copper (Cu), silver (Ag); aluminum (Al); or any alloy of these metals. In various examples, the heat spreader may include or be made of a vapor chamber, a heat pipe, a thermo syphon, one or more pulsating heat pipes or any other phase changing heat transfer device.

In Example 29, the subject matter of any one of Examples 24 to 28 can optionally include that the electronic control unit further includes thermal interface material configured to thermally couple the one or more bare dies to the heat spreader.

In Example 30, the subject matter of any one of Examples 24 to 29 can optionally include that the gap filler material is a thermal interface material.

In Example 31, the subject matter of any one of Examples 24 to 30 can optionally include that the gap filler material includes two components.

In Example 32, the subject matter of any one of Examples 24 to 31 can optionally include that the gap filler material is a silicone-based material including one or more filler materials selected from a group of filler materials consisting of one or more metal-based filler materials, one or more carbon-based filler materials, one or more ceramic-based filler materials, and/or one or more polymer-based filler materials.

In Example 33, the subject matter of any one of Examples 24 to 32 can optionally include that the heat sink structure includes a plurality of ribs extending from a heat sink base.

In Example 34, the subject matter of any one of Examples 24 to 33 can optionally include that the gap filler material is the silicone-based material including one or more metal-based filler materials.

In Example 35, the subject matter of Example 34 can optionally include that the one or more metal-based filler materials include material selected from a group consisting of aluminum oxide (Al₂O₃); zinc oxide (ZnO); silver (Ag); and/or copper (Cu).

In Example 36, the subject matter of any one of Examples 24 to 37 can optionally include that the gap filler material is the silicone-based material including one or more carbon-based filler materials.

In Example 37, the subject matter of Example 42 can optionally include that the one or more carbon-based filler materials include material selected from a group consisting of carbon nanotubes (CNTs); graphene; and/or diamond particles.

In Example 38, the subject matter of any one of Examples 24 to 37 can optionally include that the gap filler material is the silicone-based material including one or more ceramic-based filler materials.

In Example 39, the subject matter of Example 38 can optionally include that the one or more ceramic-based filler materials include material selected from a group consisting of boron nitride (BN); aluminum nitride (AlN); and/or silicon carbide (SiC).

In Example 40, the subject matter of any one of Examples 24 to 39 can optionally include that the gap filler material is the silicone-based material including one or more polymer-based filler materials.

In Example 41, the subject matter of Example 40 can optionally include that the one or more polymer-based filler materials include material selected from a group consisting of a silicone-based polmer; and/or an epoxy-based polymer.

In Example 42, the subject matter of any one of Examples 24 to 41 can optionally include that the heat spreader and the carrier are biased relative to each other via one or more springs.

In Example 43, the subject matter of any one of Examples 24 to 42 can optionally include that the electronic control unit further includes a biasing structure configured to bias the heat spreader and the carrier relative to each other in an elastic manner.

In Example 44, the subject matter of Example 43 can optionally include that the biasing structure includes a screw to fasten the heat spreader to the carrier and one or more springs positioned between a screw head of the respective screw and the carrier. Other mechanisms to load a spring may also be provided, such as one or more excenters, one or more levers, one or more cam shafts, and the like, so that the force can be applied in any manner.

In Example 45, the subject matter of any one of Examples 24 to 44 can optionally include that the heat sink structure is fixed to the carrier in a releasable manner.

In Example 46, the subject matter of Example 45 can optionally include that the heat sink structure is fixed to the carrier by one or more screws.

Example 47 is a method of manufacturing an electronic control unit. The method may include disposing a system-on-chip structure over a carrier, the system-on-chip structure comprising one or more bare dies; thermally coupling a heat spreader to the one or more bare dies; applying a gap filler material in liquid form to the heat spreader; and positioning a heat sink structure on to the gap filler material; hardening the gap filler material. The heat spreader and the carrier are biased relative to each other in an elastic manner.

Example 48 is an electronic control unit. The electronic control unit may include a carrier, a system-on-chip structure disposed over the carrier, the system-on-chip structure comprising one or more bare dies, a heat spreader thermally coupled to the one or more bare dies, a gap filler material thermally coupled to the heat spreader, and a heat sink structure thermally coupled to the gap filler material. The gap filler material is a thermal interface material. The heat spreader and the carrier are biased relative to each other in an elastic manner. The heat sink structure is fixed to the carrier in a non-releasable manner.

In Example 49, the subject matter of Example 48 can optionally include that the heat sink structure is soldered to the carrier.

Example 50 is an electronic control unit. The electronic control unit may include a carrier; a system-on-chip structure mounted on the carrier, the system-on-chip structure comprising one or more bare dies; a heat spreader thermally coupled to the one or more bare dies; a gap filler material thermally coupled to the heat spreader; and a heat sink structure thermally coupled to the gap filler material. The gap filler material is in liquid form when applied on the heat spreader and hardened after the application. The heat spreader and the carrier are resiliently coupled to each other. The heat sink structure is fixed to the carrier in a non-releasable manner.

In Example 51, the subject matter of Example 50 can optionally include that the heat sink structure is soldered to the carrier.

Example 52 is a method of manufacturing an electronic control unit. The method may include disposing a system-on-chip structure over a carrier, the system-on-chip structure comprising one or more bare dies; thermally coupling a heat spreader to the one or more bare dies; applying a gap filler material in liquid form to the heat spreader; and positioning a heat sink structure on to the gap filler material; hardening the gap filler material. The heat spreader and the carrier are biased relative to each other in an elastic manner. The heat sink structure is fixed to the carrier in a non-releasable manner.

The word "exemplary" is used herein to mean "serving as an example, instance, or illustration". Any embodiment or design described herein as "exemplary" is not necessarily to be construed as preferred or advantageous over other embodiments or designs.

The word "over" used with regards to a deposited material formed "over" a side or surface, may be used herein to mean that the deposited material may be formed "directly on", e.g. in direct contact with, the implied side or surface. The word "over" used with regards to a deposited material formed "over" a side or surface, may be used herein to mean that the deposited material may be formed "indirectly on" the implied side or surface with one or more additional layers being arranged between the implied side or surface and the deposited material.

The terms "processor" or "controller" as, for example, used herein may be understood as any kind of entity that allows handling data. The data may be handled according to one or more specific functions executed by the processor or controller. Further, a processor or controller as used herein may be understood as any kind of circuit, e.g., any kind of analog or digital circuit. A processor or a controller may thus be or include an analog circuit, digital circuit, mixed-signal circuit, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

A "vehicle" is to be understood to include any type of driving object and may be a driving object with a combustion engine, an electric driving object, a hybrid driving object, or a combination thereof. A vehicle may be or may include an automobile, a bus, a mini bus, a van, a truck, a mobile home, a vehicle trailer, a motorcycle, a bicycle, a tricycle, a moving robot, a personal transporter, a ship, a drone, an aircraft and the like.

While the disclosed subject matter has been particularly shown and described with reference to specific embodiments, it should be understood by those skilled in the art that various changes in form and detail may be made therein without departing from the spirit and scope of the invention as defined by the appended claims. The scope of the invention is thus indicated by the appended claims and all changes which come within the meaning and range of equivalency of the claims are therefore intended to be embraced.

## Claims

1. An electronic control unit, comprising:
a carrier;
a system-on-chip structure disposed over the carrier, the system-on-chip structure comprising one or more bare dies;
a heat spreader thermally coupled to the one or more bare dies;
a gap filler material thermally coupled to the heat spreader; and
a heat sink structure thermally coupled to the gap filler material;
wherein the gap filler material is a thermal interface material; and
wherein the heat spreader and the carrier are biased relative to each other in an elastic manner.

2. The electronic control unit of claim 1,
wherein the gap filler material is a silicone-based material comprising one or more filler materials selected from a group of filler materials consisting of one or more metal-based filler materials, one or more carbon-based filler materials, one or more ceramic-based filler materials, and/or one or more polymer-based filler materials.

3. The electronic control unit of claim 2,
wherein the gap filler material comprises material selected from a group consisting of aluminum oxide (Al₂O₃); zinc oxide (ZnO); silver (Ag); and/or copper (Cu).

4. The electronic control unit of claim 2,
wherein the gap filler material comprises carbon nanotubes (CNTs); graphene; and/or diamond particles.

5. The electronic control unit of claim 2,
wherein the gap filler material comprises boron nitride (BN); aluminum nitride (AlN); and/or silicon carbide (SiC).

6. The electronic control unit of any one of claims 1 to 5, wherein the carrier comprises a printed circuit board.

7. The electronic control unit of any one of claims 1 to 6,
wherein the system-on-chip structure is disposed on the carrier by a ball grid array.

8. The electronic control unit of any one of claims 1 to 7,
wherein the one or more bare dies include one or more logic processors.

9. The electronic control unit of any one of claims 1 to 8, further comprising:
thermal interface material configured to thermally couple the system-on-chip structure to the heat spreader.

10. The electronic control unit of any one of claims 1 to 9, wherein the gap filler material comprises two components.

11. The electronic control unit of any one of claims 1 to 10,
wherein the gap filler material is in liquid form when applied on the heat spreader and hardened after the application.

12. The electronic control unit of any one of claims 1 to 11, further comprising:
a biasing structure configured to bias the heat spreader and the carrier relative to each other in an elastic manner.

13. The electronic control unit of any one of claims 6 to 12,
wherein a biasing structure comprises a screw to fasten the heat spreader to the carrier and a spring positioned between a screw head of the screw and the carrier.

14. The electronic control unit of any one of claims 1 to 13,
wherein the heat sink structure includes a plurality of ribs extending from a heat sink base.

15. The electronic control unit of any one of claims 1 to 14,
wherein the heat spreader and the carrier are biased relative to each other via one or more springs.
